(19) **Europäisches Patentamt**
**European Patent Office**
**Office européen des brevets**

(11) **EP 4 641 242 B1**

(12) **EUROPEAN PATENT SPECIFICATION**

(45) Date of publication and mention
of the grant of the patent:
**05.08.2026 Bulletin 2026/32**

(51) International Patent Classification (IPC):
***G01R 35/00*** *(2006.01)* ***G01R 27/32*** *(2006.01)*

(21) Application number: **24172602.5**

(52) Cooperative Patent Classification (CPC):
**G01R 35/005;** G01R 27/32

(22) Date of filing: **26.04.2024**

(54) **SIGNAL GENERATOR SYSTEM AND METHOD FOR CALIBRATING A SIGNAL GENERATOR SYSTEM**

SIGNALGENERATORSYSTEM UND VERFAHREN ZUM KALIBRIEREN EINES SIGNALGENERATORSYSTEMS

SYSTÈME DE GÉNÉRATION DE SIGNAL ET PROCÉDÉ D'ÉTALONNAGE D'UN SYSTÈME DE GÉNÉRATION DE SIGNAL

(84) Designated Contracting States:
**AL AT BE BG CY CZ DE DK EE ES FI FR GB GR HR HU IS IT LT LU LV MC ME MK MT NL NO PL PT RO RS SE SI SK SM TR**

(43) Date of publication of application:
**29.10.2025 Bulletin 2025/44**

(73) Proprietor: **Rohde & Schwarz GmbH & Co. KG 81671 München (DE)**

(72) Inventors:
• **Baccouche, Bessem, Dr.**
  **85604 Zorneding (DE)**
• **El-Assir, Rachid**
  **81825 Munich (DE)**
• **Bochenko, Markus**
  **53340 Meckenheim (DE)**

(74) Representative: **Novagraaf Group**
**Chemin de l'Echo 3**
**1213 Onex (CH)**

(56) References cited:
JP-B2- 4 714 067     US-A1- 2008 036 648
US-A1- 2016 065 221     US-B1- 10 145 930

## Description

TECHNICAL FIELD

The present disclosure relates to a calibration of an RF signal generator system which can comprise a large number of RF output ports.

BACKGROUND

Radio frequency (RF) signal generators are used in many test systems for generating RF signals across a wide range of frequencies for testing devices-under-test (DUTs). Some DUTs, such as certain radio receivers, have a large number of RF input ports, e.g. 24 or more ports. For testing such multi-port DUTs, large systems of signal generators are required which could be composed of tens of RF ports that simultaneously forward RF signals to the DUT.

Realizing a signal generator system with such a large number of RF ports in a single block is difficult and the resulting system is often not scalable (i.e., it cannot easily be changed or adapted). In some cases, a single standard rack is not sufficient to accommodate all signal generators such that the signal generators are distributed across different racks and cumbersomely cabled.

Accurately calibrating such large, distributed systems is challenging. Typically, the system needs to be manually calibrated since it has no factory calibration. Furthermore, the number of RF ports of such a system can exceed the number of ports of a calibration device which leads to high calibration efforts. Examples of known calibration methods can be found e.g. in US 2016/065221 A1 and US 2008/036648 A1.

SUMMARY

Thus, it is an objective to provide an improved signal generator system and an improved method for calibrating a signal generator system which avoid the above-mentioned disadvantages.

The objective is achieved by the solution provided in the enclosed independent claims. Advantageous implementations of the present disclosure are further defined in the dependent claims. According to a first aspect, the present disclosure relates to a method for calibrating a signal generator system, wherein the signal generator system comprises at least two RF signal generators, wherein each of the at least two RF signal generators comprises at least one RF output port. The method comprises: connecting the RF output ports of a first group of the RF signal generators to a calibration device and performing a first calibration measurement to calculate relative errors between a reference RF output port and the remaining RF output ports of the first group; connecting the RF output ports of at least a second group of the RF signal generators to the calibration device and performing at least a second calibration measurement to calculate relative errors between a reference RF output port and the remaining RF output ports of the second group; connecting the respective reference RF output ports of the first and at least the second group of the RF signal generators to the calibration device and performing a third calibration measurement to calculate relative errors between the reference RF output ports of the first and at least the second group; calculating system wide correction terms for each RF output port of the at least two of signal generators on the basis of the relative errors calculated with the first, second and third calibration measurement; and calibrating the at least two signal generators using the correction terms.

This achieves the advantage that an RF signal generator system with a large number of RF signal generators and RF output ports can be calibrated in an efficient way. Thereby, the number of RF output ports of the system can far exceed the number of RF input ports of the calibration device.

In particular, by "splitting" the system into smaller groups (or modules) which can be individually calibrated, and subsequently calibrating these groups (or modules) amongst each other, the system can be completely calibrated with a relatively low number of individual calibration measurements.

For instance, the system comprises more than two, e.g. at least four, RF signal generators. Each of the signal generators can comprise at least two RF output ports.

For example, calibrating the at least two RF signal generators comprises adapting the RF signal generators based on the system wide correction terms which were calculated for their RF output ports.

In particular, the RF output ports of the first respectively second group refer to the RF output ports of the RF signal generator(s) in the first respectively second group.

In an embodiment, each of the at least two RF signal generators is individually addressable to form the first and at least the second group. For instance, the RF signal generators are subdivided into the first and at least the second group using their individual addresses.

The calibration device can be a vector network analyzer (VNA).

The calibration device may comprise a receiver and/or a processing unit. The processing unit could also be an external processing unit (e.g., a computer).

In an embodiment, one of the at least two signal generators is configured to transmit a time trigger signal to the other signal generators of the system; wherein a time synchronization is performed between the at least two signal generators based on the time trigger signal. This achieves the advantage that individual signal generators can be accurate calibrated amongst each other.

The signal generator which transmits the time trigger signal can be defined as a primary device, the other signal generators of the system can be secondary devices which synchronize to the primary device.

In an embodiment, the system comprises a local oscillator which is configured to generate a local oscillator signal, and/or system comprises an interface for receiving a local oscillator signal from an external device. This achieves the advantage that an accurate phase calibration can be performed in the system.

The local oscillator can be an LO of one of the signal generators or a "global" LO which is not assigned to an individual signal generator.

In an embodiment, the local oscillator signal is forwarded to each of the at least two signal generators.

In an embodiment, the method comprises the further step of: connecting the reference RF output port of the first group of the RF signal generators to a power meter and performing a power measurement; wherein the system wide correction terms are further calculated on the basis of the power measurement.

In an embodiment, during each calibration measurement, a respective calibration signal is transmitted by the RF output ports connected to the calibration device.

The calibration signals transmitted by each RF output port can be generated by the signal generator which comprises the respective RF output port. Each calibration signal can be a sinusoidal signal or a multi carrier continuous wave or a fmcw signal.

In an embodiment, the step of calculating system wide correction terms comprises estimating respective correction terms for each of the groups of RF signal generators; wherein the estimated correction terms for a group of RF signal generators are transmitted to the RF signal generators of said group, which are adapted based on said correction terms.

In an embodiment, after the calibration, the signal generator system uses the system wide correction terms automatically during its operational use. This achieves the advantage that the signal generator system can generate accurate RF signals when testing a DUT.

According to a second aspect, the present disclosure relates to a system comprising: at least two RF signal generators, wherein each of the at least two RF signal generators comprises at least one RF output port; and a calibration device which is configured to connect to RF output ports of a first group of the RF signal generators and to perform a first calibration measurement to calculate relative errors between a reference RF output port and the remaining RF output ports of the first group; wherein the calibration device is configured to connect to the RF output ports of at least a second group of the of the RF signal generators and to perform at least a second calibration measurement to calculate relative errors between a reference RF output port and the remaining RF output ports of the second group; wherein the calibration device is configured to connect to the respective reference RF output ports of the first and at least the second group of the RF signal generators and to perform a third calibration measurement to calculate relative errors between the reference RF output ports of the first and at least the second group; wherein the calibration device is configured to calculate system wide correction terms for each RF output port of the at least two signal generators on the basis of the relative error calculated with the first, second and third calibration measurement; and wherein the signal generator system is configured to perform a calibration of the at least two RF signal generators using the correction terms.

The calibration device can be a vector network analyzer. For instance, the calibration device comprises a receiver and/or a processing unit.

In an embodiment, the at least two RF signal generators together comprise at least 24 RF output ports. For instance, the system can comprise 32 or more RF output ports.

In an embodiment, the at least two RF signal generators are arranged within one or more mounting racks.

In an embodiment, the system comprises a switch matrix which is connected to at least a portion of the RF output ports of the system and which is connectable to the calibration device and/or to a device-under-test (DUT).

BRIEF DESCRIPTION OF THE DRAWINGS

The above described aspects and implementations are explained in the following description of embodiments with respect to the enclosed drawings:

| | |
|---|---|
| Fig. 1 | shows a flow diagram of a method for calibrating a signal generator system according to an embodiment; |
| Figs. 2A-D | show schematic diagrams of a signal generator system according to an embodiment; |
| Fig. 3 | shows a flow diagram of a method for calibrating the system shown in Figs. 2A-D; and |
| Fig. 4 | shows a schematic diagram of a signal generator system according to an embodiment. |

DETAILED DESCRIPTION OF EMBODIMENT

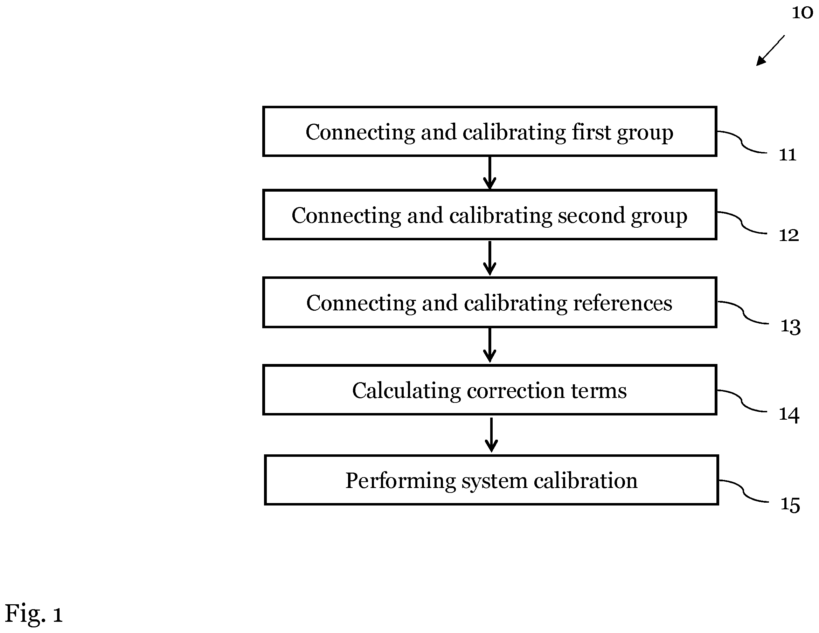

Fig. 1 shows a flow diagram of a method 10 for calibrating a signal generator system according to an embodiment. Thereby, the signal generator system comprises at least two RF signal generators, wherein each of the at least two RF signal generators comprises at least one RF output port.

The method 10 comprises the steps of: connecting 11 the RF output ports of a first group of the RF signal generators to a calibration device and performing a first calibration measurement to calculate relative errors between a reference RF output port and the remaining RF output ports of the first group of the RF signal generators; connecting 12 the RF output ports of at least a second group of the RF signal generators to the calibration device and performing at least a second calibration measurement to calculate relative errors between a reference RF output port and the remaining RF output ports of the second group of the RF signal generators; connecting 13 the respective reference RF output ports of the first and at least the second group of the RF signal generators to the calibration device and performing a third calibration measurement to calculate relative errors between the reference RF output ports of the first and at least the second group.

The method 10 further comprises: calculating 14 system wide correction terms for each RF output port of the at least two of signal generators on the basis of the relative errors calculated with the first, second and third calibration measurement; and calibrating 15 the at least two signal generators using the correction terms.

The signal generator system can have a scalable design with a large number of RF output ports. For example, the number of RF output ports of the signal generator system can exceed a number of RF input ports of the calibration device.

The calibration device could be any instrument which can receive an RF signal, since the calibration method 10 assumes raw measured data which are subsequently processed.

For instance, the calibration device is a vector network analyzer (VNA).

The calibration device may comprise a receiver and/or a processing unit. The processing unit could also be an external processing unit (e.g., a computer).

By "splitting" the system into smaller groups (or modules) which can be individually calibrated, and subsequently calibrating these groups (or modules) amongst each other, the system can be completely calibrated with a relatively small number of calibration measurements.

For instance, the system comprises more than two, e.g. at least four, RF signal generators. Each of the RF signal generators can comprise at least two RF output ports.

Each RF signal generator can be individually addressable to form the groups for calibration (in the following also referred to as calibration groups). For instance, the RF signal generators are subdivided into the first and at least the second group using their individual addresses.

For example, the RF signal generators of one group can fit into a standard rack. The RF signal generators of different groups could be arranged in different racks.

During each calibration measurement, i.e. during steps 11-13, the signal generator(s) whose RF output ports are connected to the calibration device can be configured to transmit a calibration signal via their RF output ports.

The calibration signals (also referred to as: test signals) can comprise sinusoidal signals and/or a multi carrier continuous wave signals and/or fmcw signals. In particular, the calibration signals have known signal characteristics.

The calibration device can measure a signal power and/or phase of the calibration signals received from individual RF output ports and compare said values to calculate relative errors between the RF output ports. For instance, in steps 11 to 12 the calibration device thereby calculates relative errors between one selected reference port of a calibration group and the remaining RF output ports of the group. In step 13, the calibration device can calculate relative errors between only the reference ports of the groups. Based on these results, relative errors between a reference port (e.g., of the first group) and any other RF output port of the signal can be calculated.

In general, the calibration procedure can be composed of several tasks which can be combined: an absolute power calibration at a DUT-plane, an RF output port alignment at the DUT-plane, and alignment of carrier phase and/or amplitude, and/or an alignment of a frequency response over a modulation bandwidth.

Furthermore, during the calibration measurements, one of the at least two signal generators can transmit a time trigger signal to the other signal generators of the system. A time synchronization between the signal generators can be performed based on the time trigger signal.

The signal generator which transmits the time trigger signal can be defined as a primary device of the system, the other signal generators of the system can be secondary devices which synchronize to the primary device.

The primary device can also provide its LO (local oscillator) signal to the secondary devices of the system.

Alternatively, the system can comprise a local oscillator which is separate from the signal generators an which is configured to generate the local oscillator signal and/or the system can derived the local oscillator signal from an external output or external device.

This local oscillator signal can be forwarded to each of the RF signal generators.

For instance, all RF signal generators using the same local oscillator signal allows performing a phase calibration between the individual signal generators.

Moreover, the local oscillator signal which is used during calibration is preferably identical to the local oscillator signal used when testing a DUT with the calibrated system (after calibration) .

The method may comprise the further step of: connecting the reference RF output port of the first group of RF signal generators to a power meter and performing a power measurement.

This allows performing a precise power measurement for power calibration. As the relative error between the reference port and the other RF ports of the same group as well as the reference ports of the other groups are known, it can be sufficient to perform only one such power measurement (with one reference port) .

The system wide correction terms can be further calculated 14 on the basis of this power measurement and the known errors between the RF output ports. For instance, power values for all other ports can be calculated based on results of the power measurement and the known relative errors calculated in the calibration measurements (steps 11-13).

Alternatively, the power measurement can be carried out with the calibration device, e.g. a VNA.

The step of calculating 14 system wide correction terms may comprise: estimating respective correction terms for each groups of RF signal generators. The estimated correction terms for a group can then be transmitted to the RF signal generators of said group, which are adapted based on said correction terms.

The correction terms may comprise correction data which is used by the signal generators in a group to compensate the detected error.

Preferably, after the calibration 15 of the signal generator system, the system uses the system wide correction terms automatically during its operational use, e.g., when testing a DUT.

The method 10 can be used to automatically calibrate the system and at least partially be implemented by a software and/or algorithm.

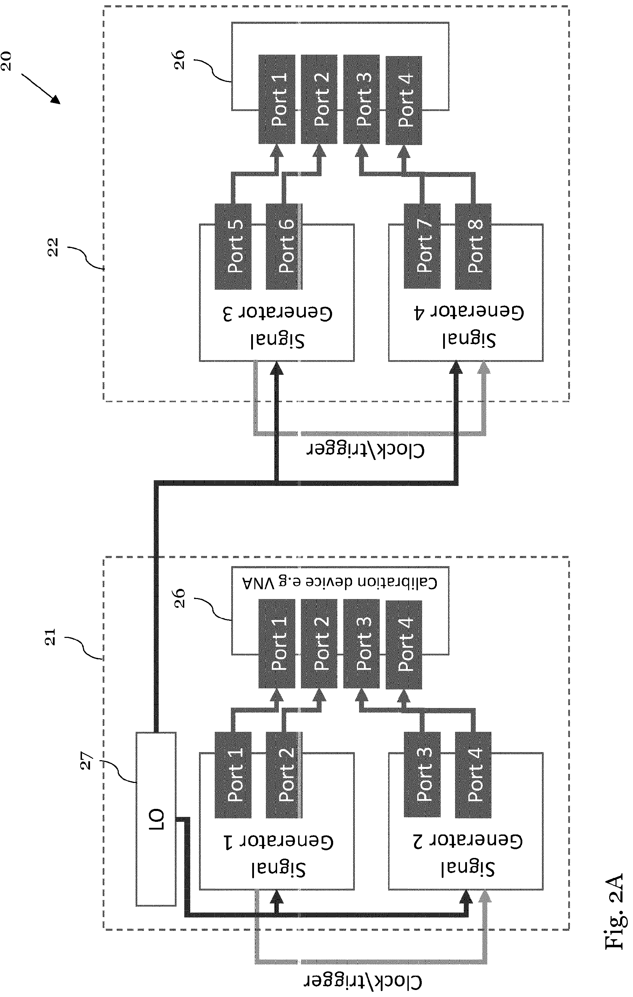

Figs. 2A-D show schematic diagrams of the signal generator system 20 according to an embodiment. The system 20 can be calibrated using the method 10 shown in Fig. 1.

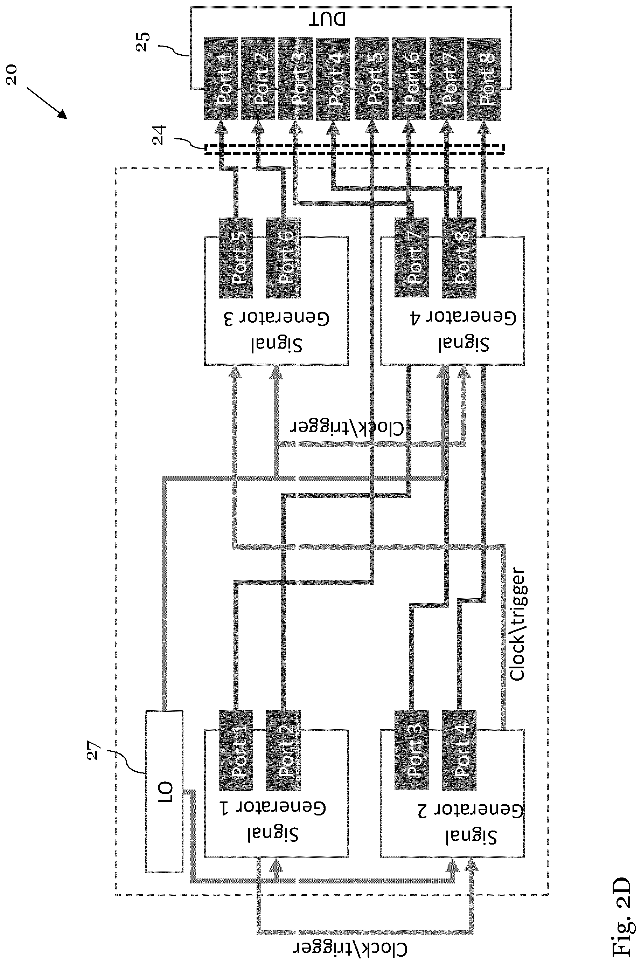

Thereby, Figs. 2A-C illustrate different steps of the calibration of the system 20 and Fig. 2D shows the calibrated signal generator system 20 connected to the DUT 25.

In general, the signal generator system 20 comprises at least two RF signal generators, wherein each of the at least two RF signal generators comprises at least one RF output port.

In the example, shown in Figs. 2A-D, the system 20 comprises four RF signal generators, each signal generator having two RF output ports (i.e., the system has in total 8 RF output ports). However, this is just an example, and the system 10 may comprise a much larger number of RF signal generators and RF output ports.

Each of the RF output ports can comprise an RF connector for connecting a cable (e.g., a coaxial cable).

As shown in Fig. 2A, the RF signal generators of the system can be separated in groups 21, 22. For example, a first group 21 comprises the ports of signal generators 1 and 2, and a second group 22 comprises the ports of signal generators 3 and 4.

The system 20 further comprises a calibration device 26 which is configured to be connected to the first group 21 of the plurality of RF output ports and to perform a first calibration measurement to calculate relative errors between a reference RF output port (e.g., ports 1) and the remaining RF output ports (e.g., ports 2-4) of the first group 21.

The calibration device 26 is further configured to connect to the second group 22 of the plurality of RF output ports and to perform a second calibration measurement to calculate relative errors between a reference RF output port (e.g., port 5) and the remaining RF output ports (e.g., port 6-8) of the second group.

The calibration device 26 can be the vector network analyzer (VNA). In the example of Fig. 2A, the calibration device 26 comprises four input ports (ports 1-4).

The system 20 can further comprise the local oscillator 27 which is configured to generate the local oscillator (LO) signal and to forward said LO signal to the signal generators.

Furthermore, one of the number of signal generators (here signal generator 1) transmits the time (or clock) trigger signal to the other signal generators of the system 20. A time synchronization can be performed between the RF signal generators based on the time trigger signal.

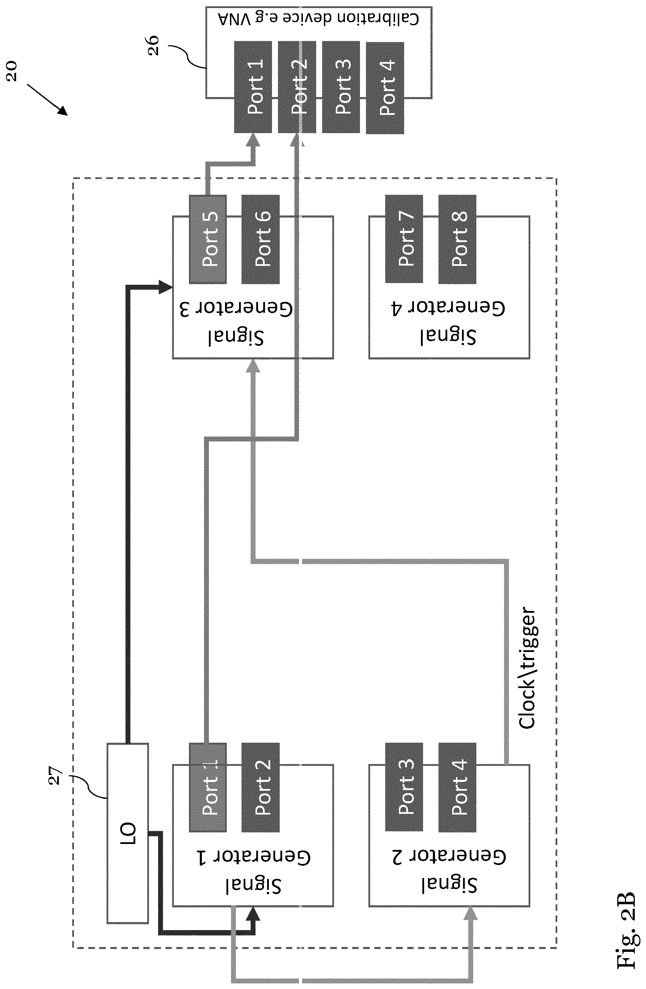

After carrying out the calibration measurements with all ports of the groups 21, 22, the respective reference ports of each group is connected to the calibration device 26 and a further (third) calibration measurement is carried out. This is shown in Fig. 2B, where port 1 of signal generator 1 and port 5 of signal generator 3 are configured as respective reference ports. Thereby, for instance, each reference port again transmits the calibration signal to the calibration device 26.

The calibration device 26 is configured to then calculate system wide correction terms for each RF output port of the number of signal generators on the basis of the relative error calculated with the first, second and third calibration measurement.

For instance, the calibration device 26 estimates the calibration settings between the calibration groups and transmits the correction terms to the calibration groups respectively to the signal generators of each calibration group. Each calibration group respectively signal generator can then be adapted accordingly.

The signal generator system 20 is configured to perform a calibration of the number of RF signal generators using the correction terms.

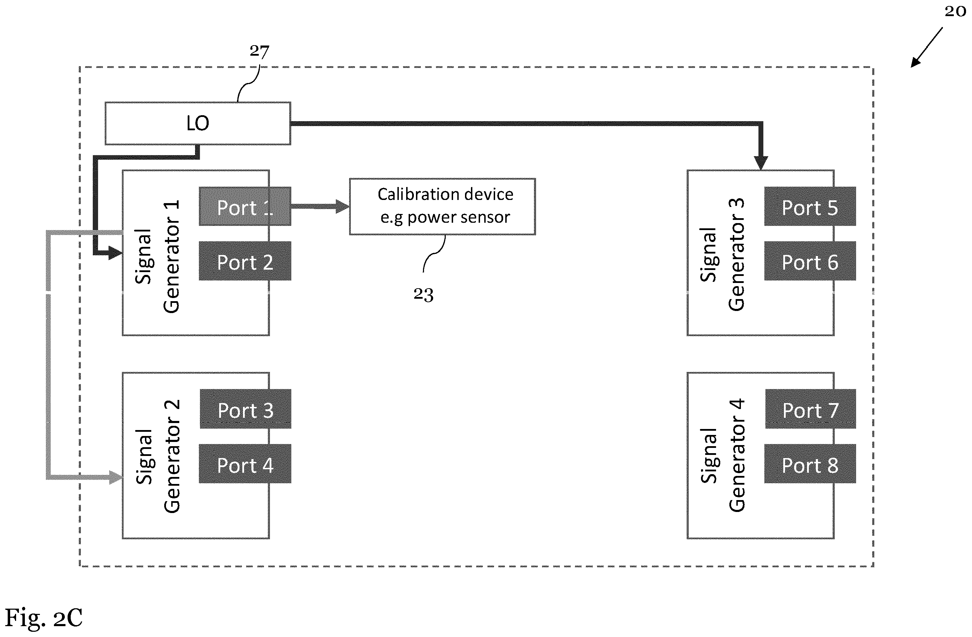

Fig. 2C shows an optional further calibration step where a power meter 23 of the system 20 is connected to the reference RF output port of the first group 21 and a power measurement is performed with said power meter 23.

The results of this power measurement can be used for a power calibration. Due to the fact that the relative error between the reference ports of each group and the relative errors between the reference RF output and the other ports within each group 21, 22 are known, this power measurement only needs to be carried out with one reference port. For all other ports, a power value can be derived from the relative errors between the ports.

The calculated corrections terms can be automatically loaded in the system 20 and used during a DUT stimulation. In Fig. 2D, the calibrated signal generator system 20 is connected to a DUT 25. In the exemplary embodiment of Fig, 2D, the system 20 and DUT 25 each have 8 ports. However, the system 20 and/or DUT could be much larger and comprise at least 24 or at least 32 RF ports.

For instance, the DUT 25 can be a radar receiver and the signal generator system 20 can be configured to transmit radar signals to the DUT 25 via its RF output ports.

The RF signal generators of the system 20 can be arranged within one or more mounting racks. For instance, the RF signal generators of the first and second group 21, 22 are arranged in different racks and/or are arranged locally separated. For instance, these groups 21, 22 are only connected during the calibration step shown in Fig. 2D.

Furthermore, an optional switch matrix 24 can be connected between to at least a portion of the plurality of RF output ports of the system and the calibration device 26 and/or the DUT 26.

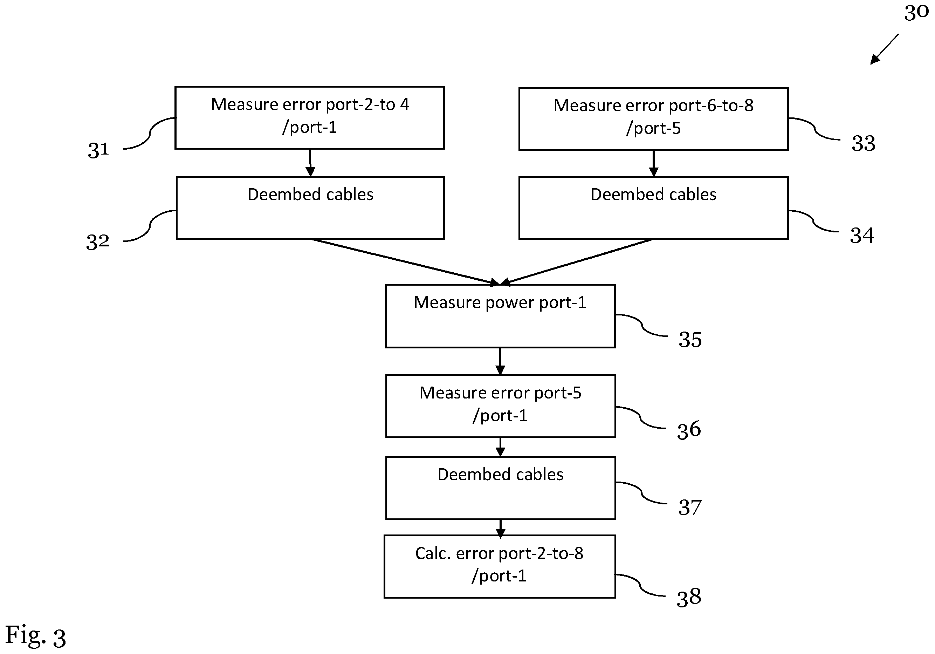

Fig. 3 shows a flow diagram of a method 30 for calibrating the system shown in Figs. 2A-D. The method 30 shown in Fig. 3 builds on the method 10 shown in Fig. 1.

In a first step 31, the RF output ports of the first group 21 are connected to the calibration device 26 and the relative error between the reference port 1 and the remaining ports 2-4 are measured. Optionally, the cables which connect the RF output ports of the first group 21 and the calibration device can be deembedded in a further step 32.

This procedure is repeated for the RF output ports of the second group 22 in steps 33-34, with port 5 being the reference port in this group.

In a subsequent step 35, an optional power measurement is performed with the reference port 1 of the first group 21 (corresponding to the measurement shown in Fig. 2C).

Then the reference ports 1 and 5 of the groups 21, 22 are connected to the calibration device 26, and the relative errors between these ports 1 and 5 are measured (step 36).

In a subsequent step 37, the cables used during step 36 can be deembeded.

Finally, relative errors between reference port 1 and all remaining ports 2-8 of the system can be determined based on the previous measurements (step 38).

The relative error between two ports of the system can be expressed in dB. For instance, the following errors could be calculated for the system 20 in Figs. 2A-D:

$$\epsilon_{1,2}^1 = c e^{j\varphi(bb\_delay_{1,2})}$$

$$\epsilon_{5,6}^2 = g_{5,6} e^{j\varphi(bb\_delay_{5,6})}$$

$$\epsilon_{1,5}^1 = g_{1,5} e^{j\varphi(bb\_delay_{1,5})}$$

$$\epsilon_{1,6}^1 = g_{1,5} e^{j\varphi(bb\_delay_{1,5})} g_{5,6} e^{j\varphi(bb\_delay_{5,6})}$$

Hereby, $\epsilon_{1,2}^1$ corresponds to a relative error between port 2 and reference port 1 in the first group 21; $\epsilon_{5,6}^2$ corresponds to a relative error between port 6 and reference port 5 in the second group 22; $\epsilon_{1,5}^1$ corresponds to a relative error between the reference ports 1 and 5 of the groups 21, 22; and $\epsilon_{1,6}^1$ corresponds to a relative error between port 6 of the second group and reference port 1 of the first group.

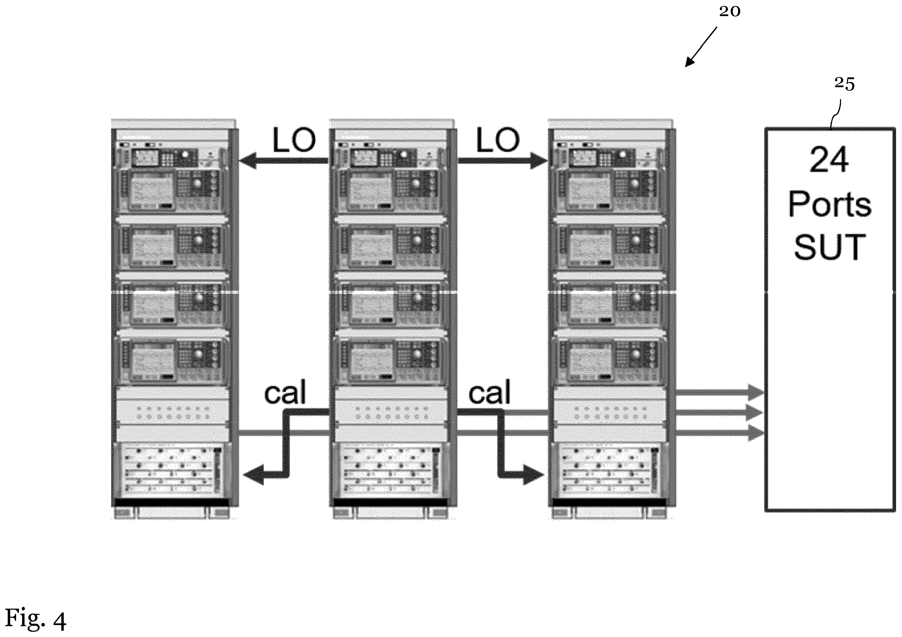

Fig. 4 shows a schematic diagram of the signal generator system 20 according to an embodiment. In the example shown in Fig. 4, the system 20 comprises a plurality of RF signal generators which are distributed over three racks, wherein a local oscillator is arranged in the center rack.

Such a system can comprise a large number of RF output ports and is connectable to a DUT 25 (or system-under-test, SUT) with 24 or more RF ports, e.g. a radar warning receiver.

Thus, the above calibration procedure allows for an easily scalable modular solution. A large signal generator system can be built by replicating and connecting smaller modules whose RF output ports initially only need to be calibrated amongst each other, followed by a calibration measurement with only the reference ports of the modules.

For instance, when adding new modules or signal generators to such a system, it is not necessary to repeat a calibration of the entire system. In contrast, it can be sufficient to only calibrate the ports of the new module/signal generator amongst each other and perform one additional calibration measurement with a reference port and new module and another reference port of the system.

The invention is defined by the appended claims.

**Claims**

1. A method (10) for calibrating a signal generator system (20), wherein the signal generator system (20) comprises at least two RF signal generators, wherein each of the at least two RF signal generators comprises at least one RF output port, the method comprising:

    connecting (11) the RF output ports of a first group (21) of the RF signal generators to a calibration device (26) and performing a first calibration measurement to calculate relative errors between a reference RF output port and the remaining RF output ports of the first group (21);

connecting (12) the RF output ports of at least a second group (22) of the RF signal generators to the calibration device (26) and performing at least a second calibration measurement to calculate relative errors between a reference RF output port and the remaining RF output ports of the second group (22);

the method **characterized in**

connecting (13) the respective reference RF output ports of the first and at least the second group (21, 22) to the calibration device (26) and performing a third calibration measurement to calculate relative errors between the reference RF output ports of the first and at least the second group (21, 22);

calculating (14) system wide correction terms for each RF output port of the at least two RF signal generators on the basis of the relative errors calculated with the first, second and third calibration measurement; and

calibrating (15) the at least two signal generators using the correction terms.

2. The method (10) of claim 1,
   wherein each of the at least two RF signal generators is individually addressable to form the first and at least the second group.

3. The method (10) of claim 1 or 2,

   wherein one of the at least two signal generators is configured to transmit a time trigger signal to the other signal generators of the system (20);
   wherein a time synchronization is performed between the at least two signal generators based on the time trigger signal.

4. The method (10) of any one of the preceding claims,

   wherein the system (20) comprises a local oscillator (27) which is configured to generate a local oscillator signal, and/or
   wherein the system comprises an interface for receiving a local oscillator signal from an external device.

5. The method (10) of claim 4,
   wherein the local oscillator signal is forwarded to each of the at least two signal generators.

6. The method (10) of any one of the preceding claims, comprising the further step of:

connecting the reference RF output port of the first group (21) of the RF signal generators to a power meter (23) and performing a power measurement;
wherein the system wide correction terms are further calculated on the basis of the power measurement.

7. The method (10) of any one of the preceding claims, wherein during each calibration measurement, a respective calibration signal is transmitted by the RF output ports connected to the calibration device (26).

8. The method (10) of any one of the preceding claims,

   wherein the step of calculating (14) system wide correction terms comprises estimating respective correction terms for each of the groups of RF signal generators;
   wherein the estimated correction terms for a group of RF signal generators are transmitted to the RF signal generators of said group, which are adapted based on said correction terms.

9. The method (10) of any one of the preceding claims, wherein, after the calibration (15), the signal generator system (20) uses the system wide correction terms automatically during its operational use.

10. A signal generator system (20), comprising:

    at least two RF signal generators, wherein each of the at least two RF signal generators comprises at least one RF output port;
    a calibration device (26) which is configured to connect to the RF output ports of a first group (21) of the RF signal generators and to perform a first calibration measurement to calculate relative errors between a reference RF output port and the remaining RF output ports of the first group (21);
    wherein the calibration device (26) is configured to connect to the RF output ports of at least a second group (22) of the of the RF signal generators and to perform at least a second calibration measurement to calculate relative errors between a reference RF output port and the remaining RF output ports of the second group (22);
    the signal generator system (20) **characterized in that**
    the calibration device (26) is configured to connect to the respective reference RF output ports of the first and at least the second group (21, 22) and to perform a third calibration measurement to calculate relative errors between the reference RF output ports of the first and at least the second group (21, 22);
wherein the calibration device (26) is configured to calculate system wide correction terms for each RF output port of the at least two signal generators on the basis of the relative error calculated with the first, second and third calibration measurement; and
wherein the signal generator system (20) is configured to perform a calibration of the at least two RF signal generators using the correction terms.

11. The signal generator system (20) of claim 10, wherein the at least two RF signal generators together comprise at least 24 RF output ports.

12. The signal generator system (20) of claim 10 or 11, wherein the at least two RF signal generators are arranged within one or more mounting racks.

13. The signal generator system (20) of any one of claims 10 to 12, further comprising:
a switch matrix (24) which is connected to at least a portion of the RF output ports of the system (20) and which is connectable to the calibration device (26) and/or to a device-under-test, DUT (25).

**Patentansprüche**

1. Verfahren (10) zum Kalibrieren eines Signalgeneratorsystems (20), wobei das Signalgeneratorsystem (20) mindestens zwei HF-Signalgeneratoren umfasst, wobei jeder der mindestens zwei HF-Signalgeneratoren mindestens einen HF-Ausgangsanschluss umfasst, das Verfahren umfassend:

Verbinden (11) der HF-Ausgangsanschlüsse einer ersten Gruppe (21) der HF-Signalgeneratoren mit einer Kalibriervorrichtung (26) und Durchführen einer ersten Kalibriermessung, um relative Fehler zwischen einem Referenz-HF-Ausgangsanschluss und den übrigen HF-Ausgangsanschlüssen der ersten Gruppe (21) zu berechnen;
Verbinden (12) der HF-Ausgangsanschlüsse mindestens einer zweiten Gruppe (22) der HF-Signalgeneratoren mit der Kalibriervorrichtung (26) und Durchführen mindestens einer zweiten Kalibriermessung, um relative Fehler zwischen einem Referenz-HF-Ausgangsanschluss und den übrigen HF-Ausgangsanschlüssen der zweiten Gruppe (22) zu berechnen;
das Verfahren **gekennzeichnet durch** das Verbinden (13) der jeweiligen Referenz-HF-Ausgangsanschlüsse der ersten und mindestens der zweiten Gruppe (21, 22) mit der Kalibriervorrichtung (26) und das Durchführen einer dritten Kalibriermessung, um relative Fehler zwischen den Referenz-HF-Ausgangsanschlüssen der ersten und mindestens der zweiten Gruppe (21, 22) zu berechnen;
Berechnen (14) systemweiter Korrekturterme für jeden HF-Ausgangsanschluss der mindestens zwei HF-Signalgeneratoren auf der Basis der relativen Fehler, die mit der ersten, zweiten und dritten Kalibriermessung berechnet werden; und
Kalibrieren (15) der mindestens zwei Signalgeneratoren unter Verwendung der Korrekturterme.

2. Verfahren (10) nach Anspruch 1, wobei jeder der mindestens zwei HF-Signalgeneratoren einzeln adressierbar ist, um die erste und mindestens die zweite Gruppe auszubilden.

3. Verfahren (10) nach Anspruch 1 oder 2,

wobei einer der mindestens zwei Signalgeneratoren konfiguriert ist, um ein Zeitauslösersignal an die anderen Signalgeneratoren des Systems (20) zu übertragen;
wobei eine Zeitsynchronisation zwischen den mindestens zwei Signalgeneratoren basierend auf dem Zeitauslösersignal durchgeführt wird.

4. System (10) nach einem der vorstehenden Ansprüche,

wobei das System (20) einen lokalen Oszillator (27) umfasst, der konfiguriert ist, um ein Signal des lokalen Oszillators zu erzeugen, und/oder wobei das System eine Schnittstelle zum Empfangen eines Signals des lokalen Oszillators von einer externen Vorrichtung umfasst.

5. Verfahren (10) nach Anspruch 4, wobei das Signal des lokalen Oszillators an jeden der mindestens zwei Signalgeneratoren weitergeleitet wird.

6. Verfahren (10) nach einem der vorstehenden Ansprüche, umfassend den weiteren Schritt:

Verbinden des Referenz-HF-Ausgangsanschlusses der ersten Gruppe (21) der HF-Signalgeneratoren mit einem Leistungsmesser (23) und Durchführen einer Leistungsmessung; wobei die systemweiten Korrekturterme ferner auf der Basis der Leistungsmessung berechnet werden.

7. System (10) nach einem der vorstehenden Ansprüche,

wobei während jeder Kalibriermessung ein jeweiliges Kalibriersignal durch die HF-Ausgangsanschlüsse übertragen wird, die mit der Kalibriervorrichtung (26) verbunden sind.

8. System (10) nach einem der vorstehenden Ansprüche,

   wobei der Schritt des Berechnens (14) systemweiter Korrekturterme ein Schätzen jeweiliger Korrekturterme für jede der Gruppen von HF-Signalgeneratoren umfasst;
   wobei die geschätzten Korrekturterme für eine Gruppe von HF-Signalgeneratoren an die HF-Signalgeneratoren der Gruppe übertragen werden, die basierend auf den Korrekturtermen angepasst werden.

9. System (10) nach einem der vorstehenden Ansprüche,
   wobei nach der Kalibrierung (15) das Signalgeneratorsystem (20) die systemweiten Korrekturterme während seines Betriebseinsatzes automatisch verwendet.

10. Signalgeneratorsystem (20), umfassend:

    mindestens zwei HF-Signalgeneratoren, wobei jeder der mindestens zwei HF-Signalgeneratoren mindestens einen HF-Ausgangsanschluss umfasst;
    eine Kalibriervorrichtung (26), die konfiguriert ist, um mit den HF-Ausgangsanschlüssen einer ersten Gruppe (21) der HF-Signalgeneratoren verbunden zu werden und um eine erste Kalibriermessung durchzuführen, um relative Fehler zwischen einem Referenz-HF-Ausgangsanschluss und den verbleibenden HF-Ausgangsanschlüssen der ersten Gruppe (21) zu berechnen;
    wobei die Kalibriervorrichtung (26) konfiguriert ist, um mit den HF-Ausgangsanschlüssen mindestens einer zweiten Gruppe (22) der HF-Signalgeneratoren verbunden zu werden und mindestens eine zweite Kalibriermessung durchzuführen, um relative Fehler zwischen einem Referenz-HF-Ausgangsanschluss und den verbleibenden HF-Ausgangsanschlüssen der zweiten Gruppe (22) zu berechnen;
    wobei das Signalgeneratorsystem (20) **dadurch gekennzeichnet ist, dass** die Kalibriervorrichtung (26) konfiguriert ist, um mit den jeweiligen Referenz-HF-Ausgangsanschlüssen der ersten und mindestens der zweiten Gruppe (21, 22) verbunden zu werden und eine dritte Kalibriermessung durchzuführen, um relative Fehler zwischen den Referenz-HF-Ausgangsanschlüssen der ersten und mindestens der zweiten Gruppe (21, 22) zu berechnen;
wobei die Kalibriervorrichtung (26) konfiguriert ist, um systemweite Korrekturterme für jeden HF-Ausgangsanschluss der mindestens zwei Signalgeneratoren auf der Basis des mit der ersten, zweiten und dritten Kalibriermessung berechneten relativen Fehlers zu berechnen; und
wobei das Signalgeneratorsystem (20) konfiguriert ist, um eine Kalibrierung der mindestens zwei HF-Signalgeneratoren unter Verwendung der Korrekturterme durchzuführen.

11. Signalgeneratorsystem (20) nach Anspruch 10, wobei die mindestens zwei HF-Signalgeneratoren zusammen mindestens 24 HF-Ausgangsanschlüsse umfassen.

12. Signalgeneratorsystem (20) nach Anspruch 10 oder 11, wobei die mindestens zwei HF-Signalgeneratoren innerhalb eines oder mehrerer Montagegestelle angeordnet sind.

13. Signalgeneratorsystem (20) nach einem der Ansprüche 10 bis 12, ferner umfassend: eine Schaltmatrix (24), die mit mindestens einem Anteil der HF-Ausgangsanschlüsse des Systems (20) verbunden ist und die mit der Kalibriervorrichtung (26) und/oder mit einem Prüfling, DUT (25), verbindbar ist.

**Revendications**

1. Procédé (10) permettant d'étalonner un système générateur de signal (20), dans lequel le système générateur de signal (20) comprend au moins deux générateurs de signal RF, dans lequel chacun des au moins deux générateurs de signal RF comprend au moins un port de sortie RF, le procédé comprenant :

   la connexion (11) des ports de sortie RF d'un premier groupe (21) des générateurs de signal RF à un dispositif d'étalonnage (26) et la mise en œuvre d'une première mesure d'étalonnage pour calculer des erreurs relatives entre un port de sortie RF de référence et les ports de sortie RF restants du premier groupe (21) ;
   la connexion (12) des ports de sortie RF d'au moins un second groupe (22) des générateurs de signal RF au dispositif d'étalonnage (26) et la mise en œuvre d'au moins une deuxième mesure d'étalonnage pour calculer des erreurs relatives entre un port de sortie RF de référence et les ports de sortie RF restants du second groupe (22) ;
   le procédé étant **caractérisé par** la connexion (13) des ports de sortie RF de référence respectifs du premier et d'au moins le second groupe (21, 22) au dispositif d'étalonnage (26) et la mise en œuvre d'une troisième mesure d'étalonnage pour calculer des erreurs relatives entre les ports de sortie RF de référence du premier et d'au moins le second groupe (21, 22) ; le calcul (14) de termes de correction à l'échelle du système pour chaque port de sortie RF des au moins deux générateurs de signal RF en fonction des erreurs relatives calculées avec les première, deuxième et troisième mesures d'étalonnage ; et l'étalonnage (15) des au moins deux générateurs de signal à l'aide des termes de correction.

2. Procédé (10) selon la revendication 1, dans lequel chacun des au moins deux générateurs de signal RF est individuellement adressable pour former le premier et au moins le second groupe.

3. Procédé (10) selon la revendication 1 ou 2,

   dans lequel l'un des au moins deux générateurs de signal est configuré pour transmettre un signal de déclenchement temporel aux autres générateurs de signal du système (20) ; dans lequel une synchronisation temporelle est mise en œuvre entre les au moins deux générateurs de signal en fonction du signal de déclenchement temporel.

4. Procédé (10) selon l'une quelconque des revendications précédentes,

   dans lequel le système (20) comprend un oscillateur local (27) qui est configuré pour générer un signal d'oscillateur local, et/ou dans lequel le système comprend une interface permettant de recevoir un signal d'oscillateur local en provenance d'un dispositif externe.

5. Procédé (10) selon la revendication 4, dans lequel le signal d'oscillateur local est acheminé à chacun des au moins deux générateurs de signal.

6. Procédé (10) selon l'une quelconque des revendications précédentes, comprenant l'étape supplémentaire consistant à :

   connecter le port de sortie RF de référence du premier groupe (21) des générateurs de signal RF à un compteur de puissance (23) et mettre en œuvre une mesure de puissance ; dans lequel les termes de correction à l'échelle du système sont calculés en outre en fonction de la mesure de puissance.

7. Procédé (10) selon l'une quelconque des revendications précédentes, dans lequel pendant chaque mesure d'étalonnage, un signal d'étalonnage respectif est transmis par les ports de sortie RF connectés au dispositif d'étalonnage (26).

8. Procédé (10) selon l'une quelconque des revendications précédentes,

   dans lequel l'étape de calcul (14) de termes de correction à l'échelle du système comprend l'estimation de termes de correction respectifs pour chacun des groupes de générateurs de signal RF ; dans lequel les termes de correction estimés pour un groupe de générateurs de signal RF sont transmis aux générateurs de signal RF dudit groupe, lesquels sont adaptés en fonction desdits termes de correction.

9. Procédé (10) selon l'une quelconque des revendications précédentes, dans lequel, après l'étalonnage (15), le système générateur de signal (20) utilise les termes de correction à l'échelle du système automatiquement pendant son utilisation opérationnelle.

10. Système générateur de signal (20), comprenant :

    au moins deux générateurs de signal RF, dans lequel chacun des au moins deux générateurs de signal RF comprend au moins un port de sortie RF ; un dispositif d'étalonnage (26) qui est configuré pour se connecter aux ports de sortie RF d'un premier groupe (21) des générateurs de signal RF et pour mettre en œuvre une première mesure d'étalonnage pour calculer des erreurs relatives entre un port de sortie RF de référence et les ports de sortie RF restants du premier groupe (21) ; dans lequel le dispositif d'étalonnage (26) est configuré pour se connecter aux ports de sortie RF d'au moins un second groupe (22) des générateurs de signal RF et pour mettre en œuvre au moins une deuxième mesure d'étalonnage pour calculer des erreurs relatives entre un port de sortie RF de référence et les ports de sortie RF restants du second groupe (22) ; le système générateur de signal (20) étant **caractérisé en ce que** le dispositif d'étalonnage (26) est configuré pour se connecter aux ports de sortie RF de référence respectifs du premier et au moins du second groupe (21, 22) et pour mettre en œuvre une troisième mesure d'étalonnage pour calculer des erreurs relatives entre les ports de sortie RF de référence du premier et au moins du second groupe (21, 22) ;

dans lequel le dispositif d'étalonnage (26) est configuré pour calculer des termes de correction à l'échelle du système pour chaque port de sortie RF des au moins deux générateurs de signal en fonction de l'erreur relative calculée avec les première, deuxième et troisième mesures d'étalonnage ; et

dans lequel le système générateur de signal (20) est configuré pour mettre en œuvre un étalonnage des au moins deux générateurs de signal RF à l'aide des termes de correction.

11. Système générateur de signal (20) selon la revendication 10,

dans lequel les au moins deux générateurs de signal RF comprennent ensemble au moins 24 ports de sortie RF.

12. Système générateur de signal (20) selon la revendication 10 ou 11,

dans lequel les au moins deux générateurs de signal RF sont agencés au sein d'un ou plusieurs racks de montage.

13. Système générateur de signal (20) selon l'une quelconque des revendications 10 à 12, comprenant en outre :

une matrice de commutation (24) qui est connectée à au moins une partie des ports de sortie RF du système (20) et qui peut être connectée au dispositif d'étalonnage (26) et/ou à un dispositif en cours de test, DUT (25).

EP 4 641 242 B1

10

```
┌─────────────────────────────────────────┐
│   Connecting and calibrating first group │ ⟋ 11
└─────────────────────────────────────────┘
                   │
                   ▼
┌─────────────────────────────────────────┐
│  Connecting and calibrating second group │ ⟋ 12
└─────────────────────────────────────────┘
                   │
                   ▼
┌─────────────────────────────────────────┐
│  Connecting and calibrating references   │ ⟋ 13
└─────────────────────────────────────────┘
                   │
                   ▼
┌─────────────────────────────────────────┐
│       Calculating correction terms       │ ⟋ 14
└─────────────────────────────────────────┘
                   │
                   ▼
┌─────────────────────────────────────────┐
│       Performing system calibration      │ ⟋ 15
└─────────────────────────────────────────┘
```

Fig. 1

Fig. 2A

EP 4 641 242 B1

Calibration device e.g VNA

Port 1

Port 2

Port 3

Port 4

26

20

Signal Generator 3

Port 5

Port 6

Signal Generator 4

Port 7

Port 8

Clock\trigger

27

LO

Signal Generator 1

Port 1

Port 2

Signal Generator 2

Port 3

Port 4

Fig. 2B

Fig. 2C

Fig. 2D

EP 4 641 242 B1

30

```
┌──────────────────────────┐          ┌──────────────────────────┐
│  Measure error port-2-to 4│          │  Measure error port-6-to-8│
│         /port-1           │          │         /port-5           │
└──────────────────────────┘          └──────────────────────────┘
```
31                                                                    33

```
┌──────────────────────────┐          ┌──────────────────────────┐
│      Deembed cables       │          │      Deembed cables       │
└──────────────────────────┘          └──────────────────────────┘
```
32                                                                    34

```
          ┌──────────────────────────┐
          │   Measure power port-1    │
          └──────────────────────────┘
```
                                          35

```
          ┌──────────────────────────┐
          │   Measure error port-5    │
          │         /port-1           │
          └──────────────────────────┘
```
                                          36

```
          ┌──────────────────────────┐
          │      Deembed cables       │
          └──────────────────────────┘
```
                                          37

```
          ┌──────────────────────────┐
          │  Calc. error port-2-to-8  │
          │         /port-1           │
          └──────────────────────────┘
```
                                          38

Fig. 3

Fig. 4

**EP 4 641 242 B1**

**Patent documents cited in the description**

- US 2016065221 A1
- US 2008036648 A1